# EUROPEAN PATENT APPLICATION

(11) **EP 1 734 593 A2**
(43) Date of publication of application: **20.12.2006**
(21) Application number: 06012327.0
(22) Date of filing: 14.06.2006
(51) Int. Cl.: H01L 45/00, H01L 27/24

(54) **Phase change memory cell defined by imprint lithography**

(30) Priority: 16.06.2005 US 154463
(71) Applicant: Infineon Technologies AG, 81669 München (DE)
(72) Inventor: Happ, Thomas Dr., 10591 Tarrytown NY (US)
(74) Representative: Jehle, Volker Armin

(57) **Abstract**

A memory cell includes a first electrode (112,114), a second electrode (118), and a phase-change material (116) between the first electrode and the second electrode. A minimum cross-sectional area (115) of a current path between the first electrode and the second electrode is defined by an imprint lithography process.

## Description

### Background

Phase-change memories include phase-change materials that exhibit at least two different states. Phase-change material may be used in memory cells to store bits of data. The states of phase-change material may be referenced to as amorphous and crystalline states. The states may be distinguished because the amorphous state generally exhibits higher resistivity than does the crystalline state. Generally, the amorphous state involves a more disordered atomic structure, while the crystalline state is an ordered lattice. Some phase-change materials exhibit more than one crystalline state, e.g. a face-centered cubic (FCC) state and a hexagonal closest packing (HCP) state. These two crystalline states have different resistivities and may be used to store bits of data. In the following description, the amorphous state generally refers to the state having the higher resistivity, and the crystalline state generally refers to the state having the lower resistivity.

Phase change in the phase-change materials may be induced reversibly. In this way, the memory may change from the amorphous state to the crystalline state, and from the crystalline state to the amorphous state, in response to temperature changes. The temperature changes to the phase-change material may be achieved in a variety of ways. For example, a laser can be directed to the phase-change material, current may be driven through the phase-change material, or current or voltage can be fed through a resistive heater adjacent the phase-change material. With any of these methods, controllable heating of the phase-change material causes controllable phase change within the phase-change material.

When a phase-change memory comprises a memory array having a plurality of memory cells that are made of phase-change material, the memory may be programmed to store data utilizing the memory states of the phase-change material. One way to read and write data in such a phase-change memory device is to control a current and/or a voltage pulse that is applied to the phase-change material. The level of current and voltage generally corresponds to the temperature induced within the phase-change material in each memory cell. To minimize the amount of power that is used in each memory cell, the cross-section of the current path through the phase-change material should be minimized.

### Summary

One embodiment of the present invention provides a memory cell. The memory cell includes a first electrode, a second electrode, and a phase-change material between the first electrode and the second electrode. A minimum cross-sectional area of a current path between the first electrode and the second electrode is defined by an imprint lithography process.

### Brief Description of the Drawings

Embodiments of the invention are better understood with reference to the followings drawings. The elements of the drawings are not necessarily to scale relative to each other. Like reference numerals designate corresponding similar parts.
Figure 1 is a block diagram illustrating one embodiment of a memory cell device.
Figure 2 illustrates a cross-sectional view of one embodiment of heater phase-change memory cells.
Figure 3 illustrates a cross-sectional view of one embodiment of a preprocessed wafer.
Figure 4 illustrates a cross-sectional view of one embodiment of the preprocessed wafer, an insulation material layer, and a transfer material layer.
Figure 5 illustrates a cross-sectional view of one embodiment of the preprocessed wafer, insulation material layer, transfer material layer, and an imprinting template.
Figure 6 illustrates a cross-sectional view of one embodiment of the preprocessed wafer, insulation material layer, and transfer material layer after removing the imprinting template.
Figure 7 illustrates a cross-sectional view of one embodiment of the preprocessed wafer, insulation material layer, and transfer material layer after etching the transfer material layer.
Figure 8 illustrates a cross-sectional view of one embodiment of the preprocessed wafer and insulation material layer after etching the insulation material layer and removing the transfer material layer.
Figure 9 illustrates a cross-sectional view of one embodiment of the preprocessed wafer, insulation material layer, and a heater material layer.
Figure 10 illustrates a cross-sectional view of one embodiment of the preprocessed wafer, insulation material layer, and heater material after planarizing the heater material layer.
Figure 11 illustrates a cross-sectional view of one embodiment of the preprocessed wafer, insulation material layer, heater material, a phase-change material layer, and an electrode material layer.
Figure 12 illustrates a cross-sectional view of one embodiment of the preprocessed wafer, insulation material layer, heater material, phase-change material, and second electrodes after etching the electrode material layer and the phase-change material layer.
Figure 13 illustrates a cross-sectional view of one embodiment of phase-change memory cells.
Figure 14 illustrates a cross-sectional view of one embodiment of a preprocessed wafer.
Figure 15 illustrates a cross-sectional view of one embodiment of the preprocessed wafer, an insulation material layer, and a transfer material layer.
Figure 16 illustrates a cross-sectional view of one embodiment of the preprocessed wafer, insulation material layer, transfer material layer, and an imprinting template.
Figure 17 illustrates a cross-sectional view of one embodiment of the preprocessed wafer, insulation material layer, and transfer material layer after removing the imprinting template.
Figure 18 illustrates a cross-sectional view of one embodiment of the preprocessed wafer, insulation material layer, and transfer material layer after etching the transfer material layer.
Figure 19 illustrates a cross-sectional view of one embodiment of the preprocessed wafer and insulation material layer after etching the insulation material layer and removing the transfer material layer.
Figure 20 illustrates a cross-sectional view of one embodiment of the preprocessed wafer, insulation material layer, and a phase-change material layer.
Figure 21 illustrates a cross-sectional view of one embodiment of the preprocessed wafer, insulation material layer, and phase-change material after planarizing the phase-change material layer.
Figure 22 illustrates a cross-sectional view of one embodiment of the preprocessed wafer, insulation material layer, phase-change material, and an electrode material layer.
Figure 23 illustrates a cross-sectional view of one embodiment of the preprocessed wafer, insulation material layer, phase-change material, and second electrodes after etching the electrode material layer.

### Detailed Description

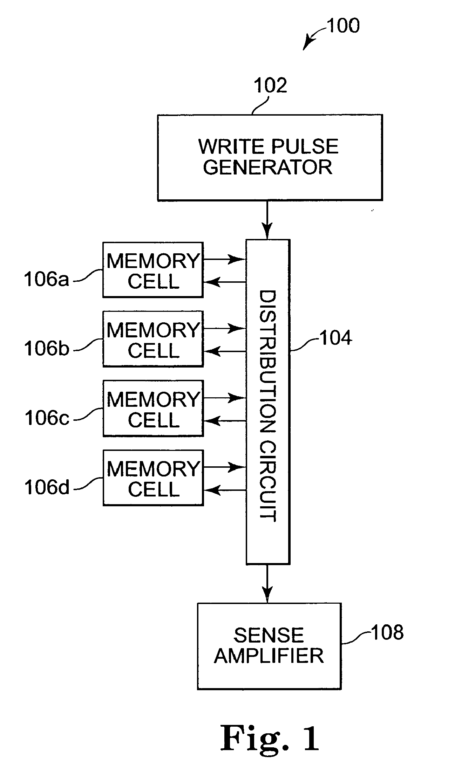

Figure 1 illustrates a block diagram of one embodiment of a memory cell device 100. Memory cell device 100 includes a write pulse generator 102, a distribution circuit 104, memory cells 106a, 106b, 106c, and 106d, and a sense amplifier 108. In one embodiment, memory cells 106a-106d are phase-change memory cells that are based on the amorphous to crystalline phase transition of the memory material.

Phase-change memory cells 106a-106d are fabricated using imprint lithography. In one embodiment, step and flash imprint lithography or another suitable imprint lithography process, such as nanotransfer printing or nanoimprinting, is used to fabricate memory cells 106a-106d. Imprint lithography is used to define the contact area between at least one metal electrode and the phase change material. The contact area defined is either the dimensions of a heater electrode or the dimensions of the phase-change material in a phase-change memory cell.

In one embodiment, write pulse generator 102 generates current or voltage pulses that are controllably directed to memory cells 106a-106d via distribution circuit 104. In one embodiment, distribution circuit 104 includes a plurality of transistors that controllably direct current or voltage pulses to the memory. In one embodiment, memory cells 106a-106d are made of a phase-change material that may be changed from an amorphous state to a crystalline state or from a crystalline state to an amorphous state under influence of temperature change. The degree of crystallinity thereby defines at least two memory states for storing data within memory cell device 100. The at least two memory states can be assigned to the bit values "0" and "1". The bit states of memory cells 106a-106d differ significantly in their electrical resistivity. In the amorphous state, a phase-change material exhibits significantly higher resistivity than in the crystalline state. In this way, sense amplifier 108 reads the cell resistance such that the bit value assigned to a particular memory cell 106a-106d is determined.

To program a memory cell 106a-106d within memory cell device 100, write pulse generator 102 generates a current or voltage pulse for heating the phase-change material in the target memory cell. In one embodiment, write pulse generator 102 generates an appropriate current or voltage pulse, which is fed into distribution circuit 104 and distributed to the appropriate target memory cell 106a-106d. The current or voltage pulse amplitude and duration is controlled depending on whether the memory cell is being set or reset. Generally, a "set" operation of a memory cell is heating the phase-change material of the target memory cell above its crystallization temperature (but below its melting temperature) long enough to achieve the crystalline state. Generally, a "reset" operation of a memory cell is heating the phase-change material of the target memory cell above its melting temperature, and then quickly quench cooling the material, thereby achieving the amorphous state.

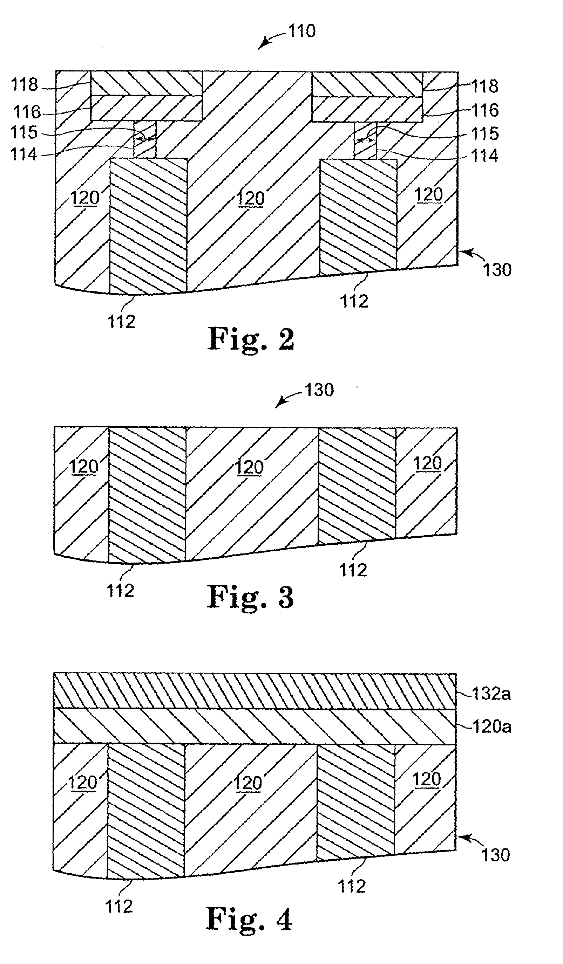

Figure 2 illustrates a cross-sectional view of one embodiment of heater phase-change memory cells 110. Each heater phase-change memory cell 110 includes a first electrode 112, a heater electrode 114, phase-change material 116, a second electrode 118, and insulation material 120. Heater electrode 114 is laterally completely enclosed by insulation material 120. The contact area between heater electrode 114 and phase-change material 116 defines the current path and hence the location of the phase-change region in phase-change material 116. The width or cross-section 115 of heater electrode 114 is defined by an imprint lithography process. In one embodiment, cross-section 115 is defined by a step and flash imprinting process, a nanotransfer printing process, a nanoimprinting process, or other suitable imprint lithography process. In one embodiment, cross-section 115 is less than approximately 100nm.

Phase-change material 116 provides a storage location for storing one bit or several bits of data. Phase-change material 116 may be made up of a variety of materials in accordance with the present invention. Generally, chalcogenide alloys that contain one or more elements from column IV of the periodic table are useful as such materials. In one embodiment, phase-change material 116 of memory cell 110 is made up of a chalcogenide compound material, such as GeSbTe or AgInSbTe. In another embodiment, the phase-change material can be chalcogen free such as GeSb, GaSb, SbTe, or GeGaSb.

A selection device, such as an active device like a transistor or diode, is coupled to first electrode 112 to control the application of current or voltage to first electrode 112, and thus to heater electrode 114 and phase-change material 116, to set and reset phase-change material 116. During a set operation of a heater phase-change memory cell 110, a set current or voltage pulse is selectively enabled to heater electrode 114 thereby heating phase-change material 116 above its crystallization temperature (but below its melting temperature). In this way, phase-change material 116 reaches its crystalline state during this set operation.

During a reset operation of a heater phase-change memory cell 110, a reset current and/or voltage pulse is selectively enabled by the selection device and sent through first electrode 112 to heater electrode 114 and phase-change material 116. The reset current or voltage quickly heats phase-change material 116 above its melting temperature, and then phase-change material 116 is quickly quench cooled to achieve its amorphous state. The following Figures 3-12 illustrate embodiments of a process for fabricating a heater phase-change memory cell 110 using imprint lithography.

Figure 3 illustrates a cross-sectional view of one embodiment of a preprocessed wafer 130. Preprocessed wafer 130 includes insulation material 120, first electrodes 112, and lower wafer layers (not shown). First electrodes 112 are tungsten plugs, copper plugs, or other suitable electrodes. Insulation material 120 is SiO₂, fluorinated silica glass (FSG), or other suitable dielectric material.

Figure 4 illustrates a cross-sectional view of one embodiment of preprocessed wafer 130, an insulation material layer 120a, and a transfer material layer 132a. Insulation material, such as SiO₂, FSG, or other suitable dielectric material, is deposited over preprocessed wafer 130 to provide insulation material layer 120a. Insulation material layer 120a is deposited using chemical vapor deposition (CVD), atomic layer deposition (ALD), metal organic chemical vapor deposition (MOCVD), spin-on, plasma vapor deposition (PVD), jet vapor deposition (JVP), or other suitable deposition technique. Transfer material, such as a photoresist material, polymer material, or other suitable transfer material, is spin coated, spray coated, or applied using another suitable process over insulation material layer 120a to provide transfer material layer 132a.

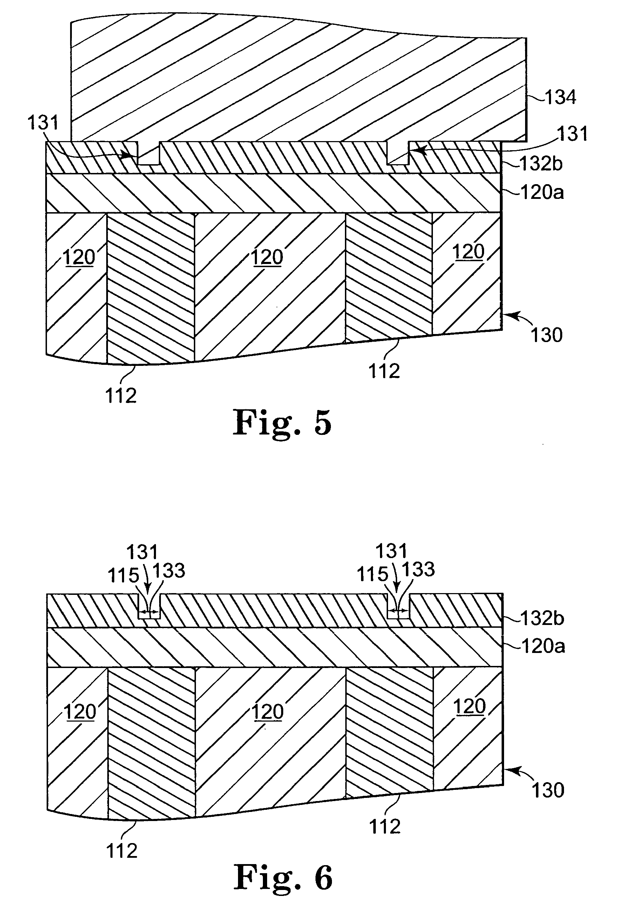

Figure 5 illustrates a cross-sectional view of one embodiment of preprocessed wafer 130, insulation material layer 120a, transfer material layer 132b, and an imprinting template 134. Imprinting template 134 is pressed into transfer material layer 132a to provide imprint transfer material layer 132b having openings as indicated at 131. In one embodiment, step and flash imprint lithography using photopolymerization molding of transfer material layer 132a is used to provide transfer material layer 132b having imprinted openings 131. In another embodiment, nanoimprinting using compression molding of a thermoplastic polymer transfer material layer 132a is used to provide transfer material layer 132b having imprinted openings 131. In other embodiments, openings 131 are patterned using another suitable imprint lithography process, such as nanotransfer printing. In one embodiment, openings 131 are positioned approximately above the center of first electrodes 112.

Figure 6 illustrates a cross-sectional view of one embodiment of preprocessed wafer 130, insulation material layer 120a, and transfer material layer 132b after removing imprinting template 134. After imprinting template 134 is removed, openings 131 of transfer material layer 132b remain. In one embodiment, the cross-section 115 of openings 131 is less than approximately 100nm. At the base of openings 131 is residual transfer material as indicated at 133.

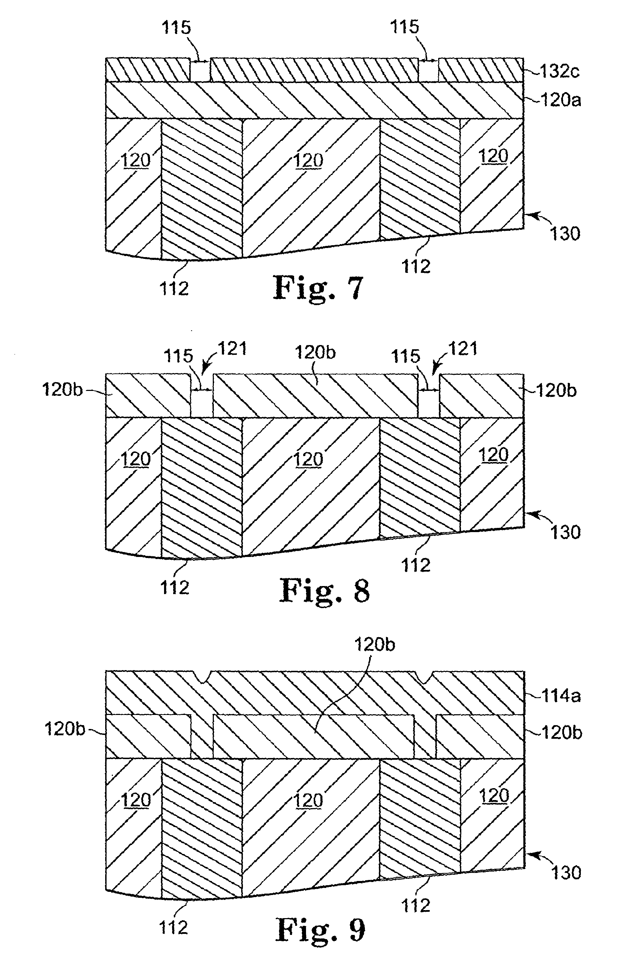

Figure 7 illustrates a cross-sectional view of one embodiment of preprocessed wafer 130, insulation material layer 120a, and transfer material layer 132c after etching transfer material layer 132b. A dry break through etch or other suitable etch is used to etch the residual transfer material 133 of transfer material layer 132b to provide transfer material layer 132c. In one embodiment, an O₂/CF₄ plasma etch is used to remove residual transfer material 133 to expose insulation material layer 120a.

Figure 8 illustrates a cross-sectional view of one embodiment of preprocessed wafer 130 and insulation material layer 120b after etching insulation material layer 120a and removing transfer material layer 132c. Insulation material layer 120a is etched using a dry etch or other suitable etch to transfer the pattern of transfer material layer 132c to insulation material layer 120a to provide insulation material layer 120b having openings 121. Openings 121 have a width or cross-section as indicated at 115. In one embodiment, openings 121 are positioned approximately above the center of first electrodes 112.

Figure 9 illustrates a cross-sectional view of one embodiment of preprocessed wafer 130, insulation material layer 120b, and heater material layer 114a. Heater material, such as TiN, TaN, W, or other suitable heater material, is deposited over insulation material layer 120b and preprocessed wafer 130 to form heater material layer 114a. Heater material fills openings 121 and contacts first electrodes 112. Heater material layer 114a is deposited using CVD, ALD, MOCVD, PVD, JVP, or other suitable deposition technique.

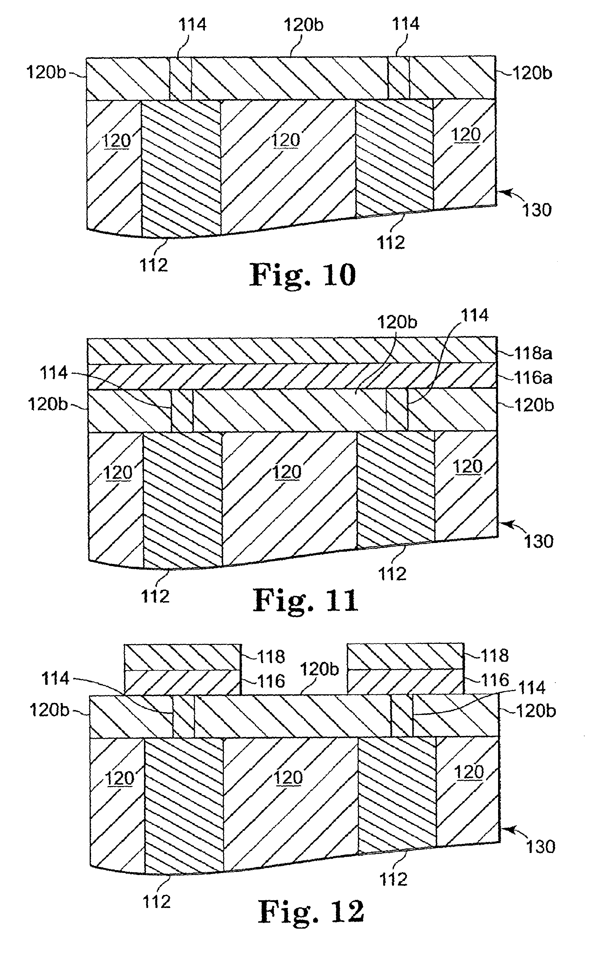

Figure 10 illustrates a cross-sectional view of one embodiment of preprocessed wafer 130, insulation material layer 120b, and heater electrodes 114 after planarizing heater material layer 114a. Heater material layer 114a is planarized using chemical mechanical planarization (CMP) or another suitable planarization technique to form heater electrodes 114 and expose insulation material layer 120b.

Figure 11 illustrates a cross-sectional view of one embodiment of preprocessed wafer 130, insulation material layer 120b, heater electrodes 114, a phase-change material layer 116a, and an electrode material layer 118a. Phase-change material, such as a calcogenic compound material or other suitable phase-change material, is deposited over insulation material layer 120b and heater electrodes 114 to provide phase-change material layer 116a. Phase-change material layer 116a is deposited using CVD, ALD, MOCVD, PVD, JVP, or other suitable deposition technique.

Electrode material, such as TiN, TaN, W, or other suitable electrode material, is deposited over phase-change material layer 116a to provide electrode material layer 118a. Electrode material layer 118a is deposited using CVD, ALD, MOCVD, PVD, JVP, or other suitable deposition technique.

Figure 12 illustrates a cross-sectional view of one embodiment of preprocessed wafer 130, insulation material layer 120b, heater electrodes 114, phase-change material 116, and second electrodes 118 after etching phase-change material layer 116a and electrode material layer 118a. Phase-change material 116a and electrode material layer 118a are masked using a photolithography process and etched using a dry etch or other suitable etch to form phase-change material 116 and second electrodes 118. Insulation material, such as SiO₂, FSG, or other suitable dielectric material, is deposited around phase-change material 116 and second electrodes 118 to form heater phase-change memory cells 110 as illustrated in Figure 2.

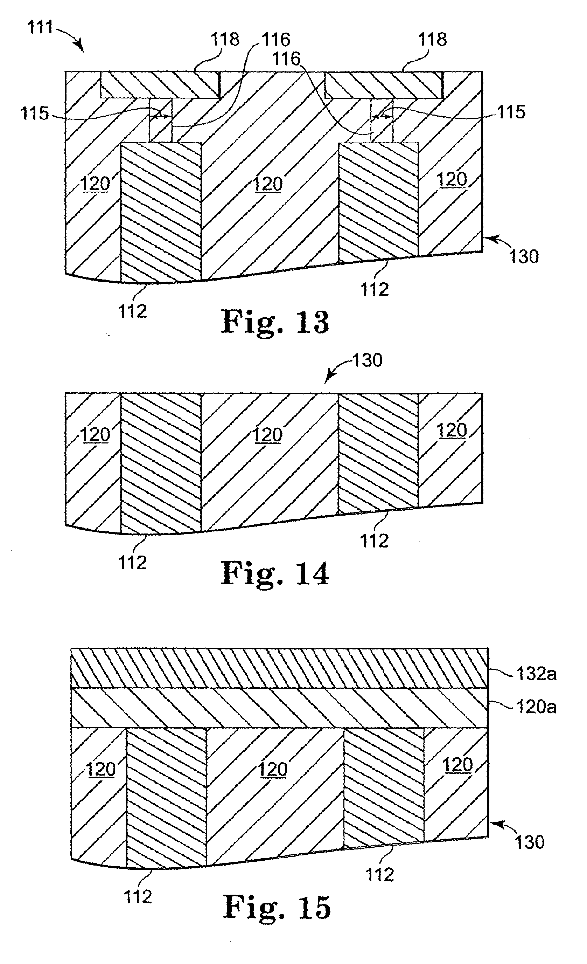

Figure 13 illustrates a cross-sectional view of one embodiment of phase-change memory cells 111. Each phase-change memory cell 111 includes a first electrode 112, phase-change material 116, a second electrode 118, and insulation material 120. Phase-change material 116 provides a storage location for storing one bit or several bits of data. Phase-change material 116 is laterally completely enclosed by insulation material 120, which defines the current path and hence the location of the phase-change region in phase-change material 116. The width or cross-section 115 of phase-change material 116 is defined by an imprint lithography process. In one embodiment, cross-section 115 is defined by a step and flash imprinting process, a nanotransfer printing process, a nanoimprinting process, or other suitable imprint lithography process. In one embodiment, cross-section 115 is less than approximately 100nm.

A selection device, such as an active device like a transistor or diode, is coupled to first electrode 112 to control the application of current or voltage to first electrode 112, and thus to phase-change material 116, to set and reset phase-change material 116. During a set operation of phase-change memory cell 111, a set current or voltage pulse is selectively enabled to phase-change material 116 thereby heating it above its crystallization temperature (but below its melting temperature). In this way, phase-change material 116 reaches its crystalline state during this set operation.

During a reset operation of phase-change memory cell 111, a reset current and/or voltage pulse is selectively enabled by the selection device and sent through first electrode 112 to phase-change material 116. The reset current or voltage quickly heats phase-change material 116 above its melting temperature, and then phase-change material 116 is quickly quench cooled to achieve its amorphous state. The following Figures 14-23 illustrate embodiments of a process for fabricating a phase-change memory cell 111 using imprint lithography.

Figure 14 illustrates a cross-sectional view of one embodiment of a preprocessed wafer 130. Preprocessed wafer 130 includes insulation material 120, first electrodes 112, and lower wafer layers (not shown). First electrodes 112 are tungsten plugs, copper plugs, or other suitable electrodes. Insulation material 120 is SiO₂, fluorinated silica glass (FSG), or other suitable dielectric material.

Figure 15 illustrates a cross-sectional view of one embodiment of preprocessed wafer 130, an insulation material layer 120a, and a transfer material layer 132a. Insulation material, such as SiO₂, FSG, or other suitable dielectric material, is deposited over preprocessed wafer 130 to provide insulation material layer 120a. Insulation material layer 120a is deposited using CVD, ALD, MOCVD, PVD, JVP, or other suitable deposition technique. Transfer material, such as a photoresist material, polymer material, or other suitable transfer material, is spin coated, spray coated, or applied using another suitable process over insulation material layer 120a to provide transfer material layer 132a.

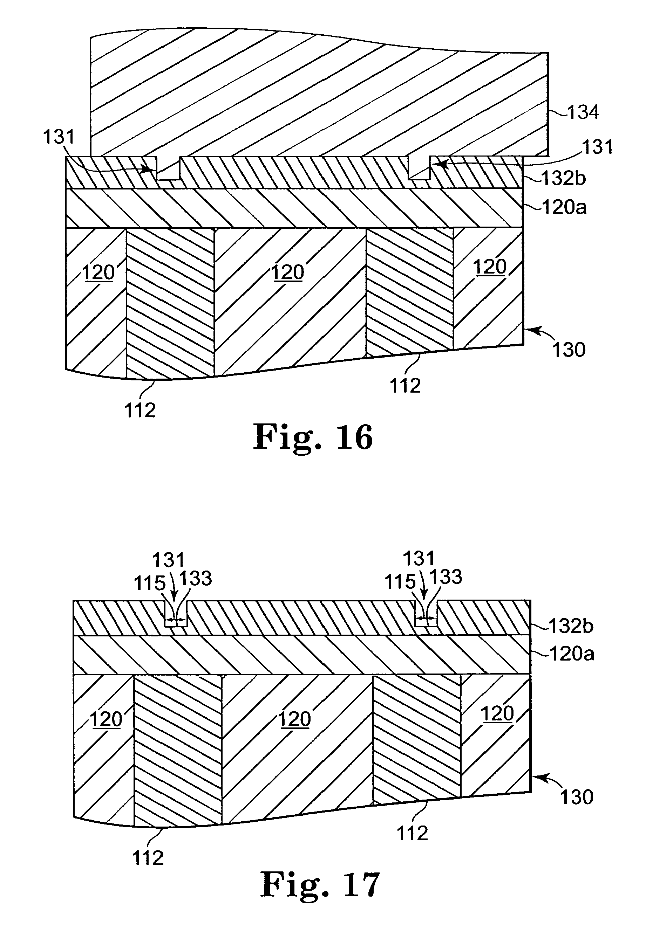

Figure 16 illustrates a cross-sectional view of one embodiment of preprocessed wafer 130, insulation material layer 120a, transfer material layer 132b, and an imprinting template 134. Imprinting template 134 is pressed into transfer material layer 132a to provide transfer material layer 132b having openings as indicated at 131. In one embodiment, step and flash imprint lithography using photopolymerization molding of transfer material layer 132a is used to provide transfer material layer 132b having imprinted openings 131. In another embodiment, nanoimprinting using compression molding of a thermoplastic polymer transfer material layer 132a is used to provide transfer material layer 132b having imprinted openings 131. In other embodiments, openings 131 are patterned using another suitable imprint lithography process, such as nanotransfer printing. In one embodiment, openings 131 are positioned approximately above the center of first electrodes 112.

Figure 17 illustrates a cross-sectional view of one embodiment of preprocessed wafer 130, insulation material layer 120a, and transfer material layer 132b after removing imprinting template 134. After imprinting template 134 is removed, openings 131 of transfer material layer 132b remain. In one embodiment, the cross-section 115 of openings 131 is less than approximately 100nm. At the base of openings 131 is residual transfer material as indicated at 133.

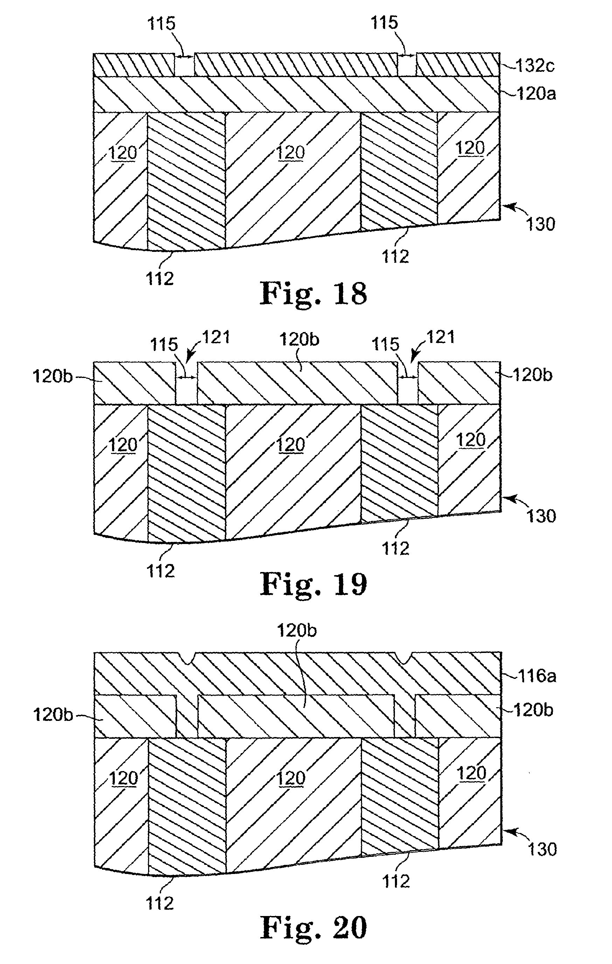

Figure 18 illustrates a cross-sectional view of one embodiment of preprocessed wafer 130, insulation material layer 120a, and transfer material layer 132c after etching transfer material layer 132b. A dry break through etch or other suitable etch is used to etch the residual transfer material 133 of transfer material layer 132b to provide transfer material layer 132c. In one embodiment, an O₂/CF₄ plasma etch is used to remove residual transfer material 133 to expose insulation material layer 120a.

Figure 19 illustrates a cross-sectional view of one embodiment of preprocessed wafer 130 and insulation material layer 120b after etching insulation material layer 120a and removing transfer material layer 132c. Insulation material layer 120a is etched using a dry etch or other suitable etch to transfer the pattern of transfer material layer 132c to insulation material layer 120a to provide insulation material layer 120b having openings 121. Openings 121 have a width or cross-section as indicated at 115. In one embodiment, cross-section 115 is less than approximately 100nm. In one embodiment, openings 121 are positioned approximately above the center of first electrodes 112.

Figure 20 illustrates a cross-sectional view of one embodiment of preprocessed wafer 130, insulation material layer 120b, and a phase-change material layer 116a. Phase-change material, such as a calcogenic compound material or other suitable phase-change material, is deposited over insulation material layer 120b and preprocessed wafer 132 to provide phase-change material layer 116a. Phase-change material fills openings 121 and contacts first electrodes 112. Phase-change material layer 116a is deposited using CVD, ALD, MOCVD, PVD, JVP, or other suitable deposition technique.

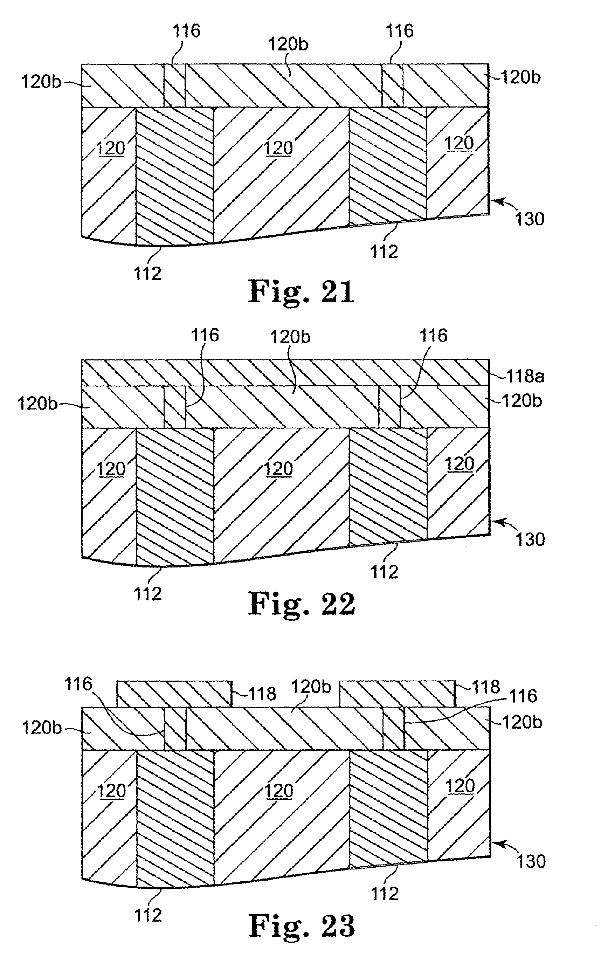

Figure 21 illustrates a cross-sectional view of one embodiment of preprocessed wafer 130, insulation material layer 120b, and phase-change material 116 after planarizing phase-change material layer 116a. Phase-change material layer 116a is planarized using CMP or another suitable planarization technique to provide storage locations and expose insulation material layer 120b.

Figure 22 illustrates a cross-sectional view of one embodiment of preprocessed wafer 130, insulation material layer 120b, phase-change material 116, and electrode material layer 118a. Electrode material, such as TiN, TaN, W, or other suitable electrode material, is deposited over insulation material layer 120b and phase-change material 116 to provide electrode material layer 118a. Electrode material layer 118a is deposited using CVD, ALD, MOCVD, JVD, JVP, or other suitable deposition technique.

Figure 23 illustrates a cross-sectional view of one embodiment of preprocessed wafer 130, insulation material layer 120b, phase-change material 116, and second electrodes 118 after etching electrode material layer 118a. Electrode material layer 118a is masked using a photolithography process and etched using a dry etch or other suitable etch to form second electrodes 118. Insulation material, such as SiO₂, FSG, or other suitable dielectric material, is deposited around second electrodes 118 to form phase-change memory cells 111 as illustrated in Figure 13.

Embodiments of the invention provide phase-change memory cells defined by imprint lithography. Imprint lithography is used to define the dimensions of a heater electrode or the dimensions of the phase-change material in the phase-change memory cells. By reducing the cross-section of the current path through the phase-change material in the phase-change memory cells, the amount of power that is used in each memory cell can be reduced.

## Claims

1. A memory cell comprising:
a first electrode;
a second electrode; and
a phase-change material between the first electrode and the second electrode,
wherein a minimum cross-sectional area of a current path between the first electrode and the second electrode is defined by an imprint lithography process.

2. The memory cell of claim 1, wherein the imprint lithography process comprises a step and flash imprint lithography process.

3. The memory cell of claim 1, wherein the imprint lithography process comprises a nanotransfer printing lithography process.

4. The memory cell of claim 1, wherein the imprint lithography process comprises a nanoimprint lithography process.

5. The memory cell of claim 1, wherein the phase-change material comprises a chalcogenide.

6. The memory cell of claim 1, wherein the phase-change material comprises a chalcogen free material.

7. A memory cell comprising:
a first electrode;
a second electrode; and
a phase-change material between the first electrode and the second electrode, the phase-change material having a cross-sectional area defined by an imprint lithography process.

8. The memory cell of claim 7, wherein the imprint lithography process comprises a step and flash imprint lithography process.

9. The memory cell of claim 7, wherein the imprint lithography process comprises a nanotransfer printing lithography process.

10. The memory cell of claim 7, wherein the imprint lithography process comprises a nanoimprint lithography process.

11. The memory cell of claim 7, wherein the phase-change material comprises a chalcogenide.

12. The memory cell of claim 7, wherein the phase-change material comprises a chalcogen free material.

13. A memory cell comprising:
a first electrode;
a heater electrode adjacent the first electrode, the heater electrode having a cross-sectional area defined by an imprint lithography process;
a phase-change material adjacent the heater electrode; and
a second electrode adjacent the phase-change material.

14. The memory cell of claim 13, wherein the imprint lithography process comprises a step and flash imprint lithography process.

15. The memory cell of claim 13, wherein the imprint lithography process comprises a nanotransfer printing lithography process.

16. The memory cell of claim 13, wherein the imprint lithography process comprises a nanoimprint lithography process.

17. The memory cell of claim 13, wherein the phase-change material comprises a chalcogenide.

18. The memory cell of claim 13, wherein the phase-change material comprises a chalcogen free material.

19. A memory device comprising:
a write pulse generator for generating a write pulse signal;
a sense amplifier for sensing a read signal;
a distribution circuit; and
a plurality of phase-change memory cells each capable of defining at least a first state and a second state, each memory cell further comprising phase-change material having a cross-sectional area defined by an imprint lithography process.

20. The memory cell of claim 19, wherein the imprint lithography process comprises a step and flash imprint lithography process.

21. The memory cell of claim 19, wherein the imprint lithography process comprises a nanotransfer printing lithography process.

22. The memory cell of claim 19, wherein the imprint lithography process comprises a nanoimprint lithography process.

23. The memory cell of claim 19, wherein the phase-change material comprises a chalcogenide.

24. A memory device comprising:
a write pulse generator for generating a write pulse signal;
a sense amplifier for sensing a read signal;
a distribution circuit; and
a plurality of phase-change memory cells each capable of defining at least a first state and a second state, each memory cell further comprising a heater electrode having a cross-sectional area defined by an imprint lithography process.

25. The memory cell of claim 24, wherein the imprint lithography process comprises a step and flash imprint lithography process.

26. The memory cell of claim 24, wherein the imprint lithography process comprises a nanotransfer printing lithography process.

27. The memory cell of claim 24, wherein the imprint lithography process comprises a nanoimprint lithography process.

28. The memory cell of claim 24, wherein the phase-change material comprises a chalcogenide.

29. A method for fabricating a memory cell, the method comprising:
providing a preprocessed wafer having a first electrode;
depositing an insulation material layer over the preprocessed wafer;
applying a transfer material layer over the insulation material layer;
imprinting the transfer material layer to form an opening;
etching the transfer material layer and the insulation material layer through the opening to expose the first electrode;
removing the transfer material layer;
depositing phase-change material in the opening; and
fabricating a second electrode in contact with the phase-change material.

30. The method of claim 29, wherein imprinting the transfer material layer comprises step and flash imprinting.

31. The method of claim 29, wherein imprinting the transfer material layer comprises nanotransfer printing.

32. The method of claim 29, wherein imprinting the transfer material layer comprises nanoimprinting.

33. The method of claim 29, wherein depositing the phase-change material comprises depositing a chalcogenide

34. A method for fabricating a memory cell, the method comprising:
providing a preprocessed wafer having a first electrode;
depositing an insulation material layer over the preprocessed wafer;
applying a transfer material layer over the insulation material layer;
imprinting the transfer material layer to form an opening;
etching the transfer material layer and the insulation material layer through the opening to expose the first electrode;
removing the transfer material layer;
depositing heater material in the opening;
depositing a phase-change material layer over the heater material;
depositing an electrode material layer over the phase-change material layer; and
etching the electrode material layer and the phase-change material layer to form a second electrode and a memory storage location.

35. The method of claim 34, wherein imprinting the transfer material layer comprises step and flash imprinting.

36. The method of claim 34, wherein imprinting the transfer material layer comprises nanotransfer printing.

37. The method of claim 34, wherein imprinting the transfer material layer comprises nanoimprinting.

38. The method of claim 34, wherein depositing the phase-change material comprises depositing a chalcogenide.
